# EUROPEAN PATENT SPECIFICATION

(11) **EP 4 224 171 B1**
(45) Date of publication and mention of the grant of the patent: **09.10.2024**
(21) Application number: 23155360.3
(22) Date of filing: 07.02.2023
(51) Int. Cl.: G01P 5/16, B64D 15/12, G01P 5/165, G01P 21/02

(54) **DYNAMIC AIR DATA PROBE PROGNOSTICS HEALTH MONITORING EDGE DEVICE**
RANDVORRICHTUNG ZUR PROGNOSE DER GESUNDHEITSÜBERWACHUNG EINER DYNAMISCHEN LUFTDATENSONDE
DISPOSITIF PÉRIPHÉRIQUE DE SURVEILLANCE DE SANTÉ DE SONDE DE DONNÉES D'AIR DYNAMIQUE

(30) Priority: 07.02.2022 IN 202241006328
(43) Date of publication of application: 09.08.2023
(73) Proprietor: ROSEMOUNT AEROSPACE INC., Burnsville, MN 55306-4898 (US)
(72) Inventor: BALASUBRAMANIAN, Rameshkumar, Apple Valley, MN (US); ROESKE, Cal, Eagan, MN (US)
(74) Representative: Dehns

(56) References cited:
- EP-A1- 3 739 411
- EP-A2- 2 551 660
- US-A1- 2019 041 830
- US-A1- 2020 348 662

## Description

### BACKGROUND

The disclosed subject matter relates generally to prognostics health monitoring, and more particularly, to a modular prognostics health monitoring system for air data probes.

Air data probes are safety-critical sensors installed on all modern aircraft to measure parameters like total pressure, static pressure, and in some cases, pressures for angle of attack and side slip. These probes are external to the aircraft and are exposed to harsh weather conditions and subzero temperatures. Such conditions may cause ice formation on part of the probe resulting in incorrect measurement of air data parameters. Accordingly, resistive heating elements are installed in the air data probes to prevent ice formation. To heat the probe, an operational voltage is provided through the heating element. Prolonged usage and frequent switching (i.e., between the OFF state and ON state) can lead to an abrupt failure of the heating element. When the heating element breaks down, the probe must be replaced prior to subsequent takeoff of the aircraft to ensure continued monitoring air data parameters. Thus, health monitoring of air data probes is critical. Edge devices and methods are disclosed in EP 3 739 411 A and EP 2 551 660 A2.

Existing aircraft-based health monitoring systems can monitor various probe parameters but lack the sophistication to analyze the data using complex health monitoring algorithms. Data must be transmitted to a ground station for this purpose. Similarly, modification of the monitoring parameters in current systems requires the removal and reinstallation of the updated data acquisition module. A need exists for a dynamic health monitoring system for real-time prediction of remaining useful life and predicted failure of an air data probe with a high level of accuracy.

### SUMMARY

An edge device for use in a system for monitoring a vehicle-borne probe is provided as defined by claim 1.

A method for operating an edge device in a system for monitoring a vehicle-borne probe is provided as defined by claim 8.

### BRIEF DESCRIPTION OF THE DRAWINGS

FIG. 1 is a diagram of a prognostics health monitoring system.
FIG. 2 is a diagram of an edge device of the prognostics health monitoring system.
FIG. 3 is a diagram of select software of the edge device.
FIG. 4A is a plot showing the operation of a stage-1 data processing application and a pre-loaded stage-2 data processing application.
FIG. 4B is a plot showing the operation of a stage-1 data processing application and a dynamically loaded stage-2 data processing application.
FIG. 4C is a plot showing the operation of a stage-1 data processing application and an alternative dynamically loaded stage-2 data processing application.
FIG. 5 is a diagram of a smart coordinator of the prognostics health monitoring system.
FIG. 6 is a plot showing the operation of a stage-3 data analytics application implemented by the smart coordinator.
FIG. 7 is a flow chart illustrating a method of determining a remaining useful life and predicting imminent failure of a probe, as implemented by a cloud infrastructure of the prognostics health monitoring system.

While the above-identified figures set forth one or more embodiments of the present disclosure, other embodiments are also contemplated, as noted in the discussion. In all cases, this disclosure presents the invention by way of representation and not limitation. It should be understood that numerous other modifications and embodiments can be devised by those skilled in the art, which fall within the scope and spirit of the principles of the invention. The figures may not be drawn to scale, and applications and embodiments of the present invention may include features and components not specifically shown in the drawings.

### DETAILED DESCRIPTION

This disclosure presents a prognostics health monitoring (PHM) system and method for estimating a remaining useful life (RUL) and predicting imminent failure of a vehicle-borne probe, such as an aircraft air data probe. The system includes one or more sensors in communication with each monitored probe. An edge device associated with a probe receives the sensed data and performs various levels of data analytics. Data outputs from each edge device are sent to a smart coordinator of the system for additional monitoring and analysis. The coordinator packages the data and sends it to a cloud infrastructure and ground station for detailed analysis.

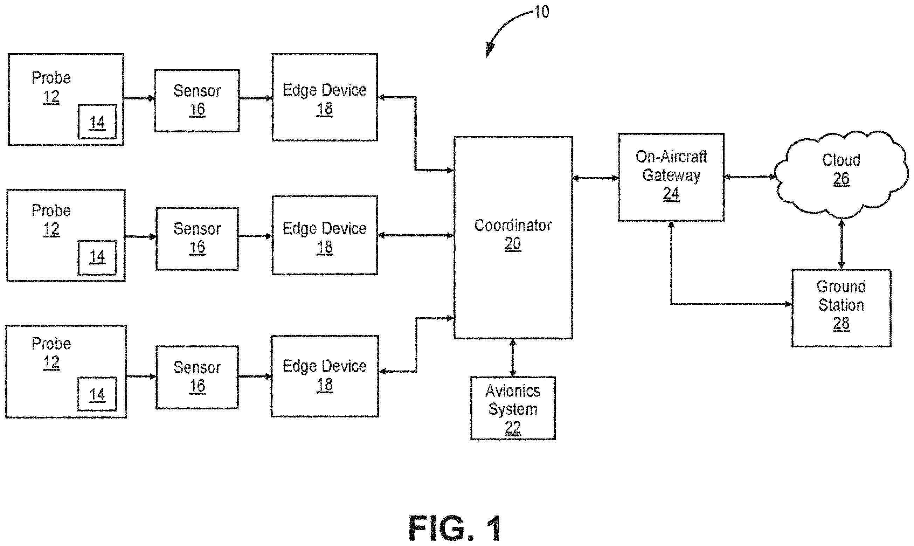

FIG. 1 is a schematic block diagram of an exemplary embodiment of multi-stage PHM system 10 for monitoring one or more air data probes 12. System 10 includes a sensor 16 in communication with each probe 12 for monitoring characteristics of a heating element 14 of each probe 12. In some embodiments, more than one sensor 16 can be in communication with a respective probe 12. Each sensor 16 is further in communication with a dynamic edge device 18 for performing initial processing and monitoring of sensed data. Each edge device 18 is in communication with smart coordinator 20 which monitors pre-processed data from each edge device 18, as well as aircraft parameters from one or more avionics systems 22. On-aircraft gateway 24 connects coordinator 20 with cloud 26 and ground station 28. The individual components of system 10 are discussed in greater detail below.

Each probe 12 can be a pitot probe, total air temperature (TAT) probe, or angle-of-attack (AOA) probe, to name a few non-limiting examples, configured to measure aircraft operational parameters such as pressure and/or temperature. In an alternative embodiment, probes 12 can be mounted to other types of (non-aerial) vehicles and can be suitable for measuring operational parameters of such vehicles. Each probe 12 includes a resistive heating element 14, such as a heater wire, powered by a source of alternating (AC) or direct (DC) current. The flow of current through heating element 14 provides heating to the associated probe 12 to prevent ice accretion. The one or more sensors 16 in communication with a respective probe 12 can measure characteristics of an associated heating element 14, such as current, capacitance, and/or voltage.

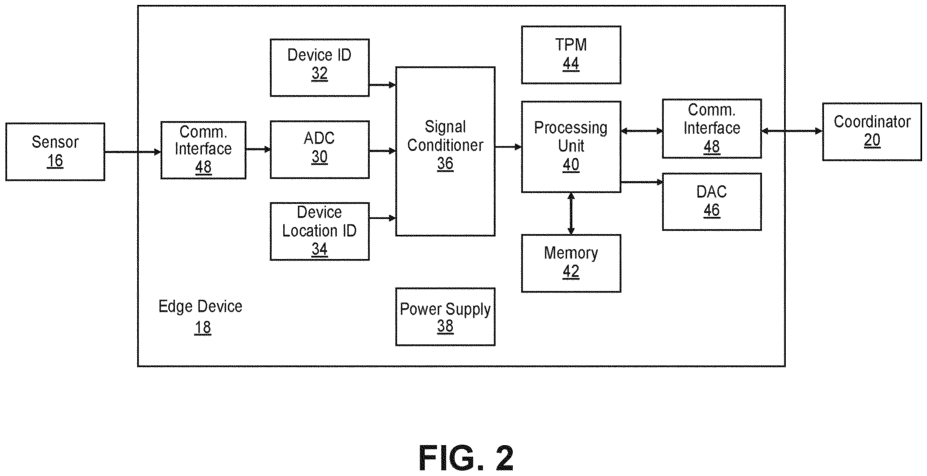

Each sensor 16 outputs sensed heating element 14 data to an associated edge device 18. FIG. 2 is a schematic block diagram of an exemplary edge device 18 as a modular end node. Shown in FIG. 2 as part of edge device 18 are analog-to-digital converter (ADC) 30, device identification (ID) 32, device location identification (ID) 34, signal conditioner 36, power supply 38, processing unit 40, memory 42, trusted platform module (TPM) 44, digital-to-analog converter (DAC) 46, and input/output communication interfaces 48.

In operation of system 10, data from sensor 16 is received by edge device 18 via a wired (e.g., Ethernet, AFDX, ARINC 429, RS232/422/485, CAN, etc.) or wireless (e.g., Bluetooth, Wi-Fi, cellular, etc.) first/input communication interface 48. The latter type of connection permits a sensor 16 and associated edge device 18 to be in physically separate locations on the aircraft. ADC 30 converts the received sensor 16 output signals to digital signals. Subsequent signal conditioning (e.g., filtering, linearization, amplification, etc.) is performed by signal conditioner 36. Power supply 38 can be any suitable source of power, such as a battery, energy harvesting devices, or other sources on the aircraft. Upon power-up of edge device 18, processing unit 40 reads device ID 32 and device location ID 34 to determine/confirm the type and physical location of edge device 18. Processing unit 40 then reads the device configuration stored in memory 42 and configures edge device 18 based on device ID 32 and location ID 34. Memory 42 can further store data and applications for access by processing unit 40. Processing unit 40 can be, for example, a microprocessor or microcontroller configured to perform various data processing and analysis tasks, discussed in greater detail below, and output processed data to coordinator 20 via second/output communication interface 48. Output communication interface 48 may be of the wired or wireless type discussed above with respect to input communication interface 48. Output communication interface 48 is configured to exchange data with coordinator 20. TPM 44 is at least one of various cybersecurity measures (e.g., certificate management, advanced encryption, etc.) implemented by edge device 18 for securely communicating with interfacing devices and systems.

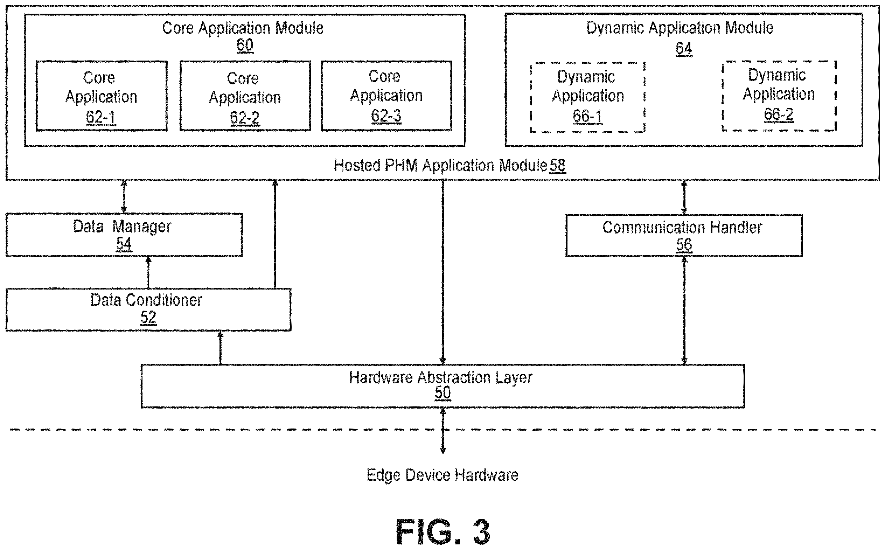

FIG. 3 is a schematic block diagram of select software of edge device 18. Edge device 18 software can include hardware abstraction layer 50, data conditioner 52, PHM data manager 54, communication handler 56, and hosted PHM application module 58. Hardware abstraction layer 50 includes various board support packages and device drivers for abstracting hardware interfaces (e.g., device ID, discrete input/output, analog input/output, communication interfaces, etc.) of edge device 18. Hardware abstraction layer can abstract higher level software modules from any changes in such hardware. Data conditioner 52 acquires signals from the hardware at the configured rate, filters the data, and stores the data in memory 42 (shown in FIG. 2) which is accessible by data manager 54. Data manager 54 manages edge device 18 data according to its configuration. Data manager 54 implements a publish/subscribe methodology to enable one or more applications of hosted PHM application module 58 to publish processed data while others of the applications can subscribe for data for processing. Any published data are automatically broadcast to any applications which have subscribed for that data. Data manager 54 further allows for space and time partitioning of the various hosted PHM applications which enables multiple Development Assurance Level (DAL) software/applications to coexist in edge device 18. Communication handler 56 implements wrapper software to the various wired and/or wireless communication interfaces implemented in edge device 18. Communication handler 56 provides standard software interfaces (e.g., SDK or APIs) to interfacing hosted PHM applications to enable communication with the external systems. Communication handler 56 uses cybersecurity measures (e.g., TPM, EAP-TLS, certificate management, advanced encryption, etc.) implemented in the operating system (OS) to ensure security of edge device 18 and its communications with interfacing devices/systems, including coordinator 20, and other avionics systems.

Hosted PHM application module 58 can include core application module 60 with core applications 62-1, 62-2, and 62-3 (collectively referred to as "core applications 62"), and dynamic application module 64 with dynamic applications 66-1 and 66-2 (collectively referred to as "dynamic applications 66"). Various embodiments of edge device 18 can include any number of 1 to *n* core applications 62 and/or 0 to *m* dynamic applications 66. In some embodiments, core applications 62 and/or dynamic applications 66 can be incorporated into a field load bundle that enables updating of the hosted applications. The field load bundle can additionally and/or alternatively include any of the following sections for updating: device configuration information (e.g., edge device ID and location ID, serial number, part number, etc.), cybersecurity (e.g., certificates, encryption keys, etc.), device-specific software containing configuration information (e.g., input sample size, sampling rate, output rate, parameters, communication protocol, etc.), and software/firmware (e.g., executable object code, parameter data item, etc.).

Core applications 62 enable implementation of the PHM functions of edge device 18. More specifically, core application 62-1 can be an advanced local PHM data repository for implementing reusable data analytics algorithms (e.g., Fast Fourier Transform (FFT), arc fault detection, etc.) local to edge device 18. The various hosted PHM applications can use the algorithms implemented in the data analytics repository instead of duplicating their implementation. Core application 62-2 can be a stage-1 pre-PHM data processing application for continuously monitoring sensed heater 14 data, and for performing coarse-PHM data analytics on the sensed data using one or more coarse-PHM data analytics algorithms. Any resulting coarse data analytics outputs can be sent to coordinator 20, as well as further monitored by one of the dynamic applications 66, as is discussed in greater detail below. Core application 62-3 can be a field loader application for updating any of the bundled applications or sections discussed above.

Dynamic applications 66 are optional PHM applications that can be temporary or short-term in nature. More specifically, dynamic applications 66 can be automatically loaded onto edge device 18 by coordinator 20 and/or enabled/activated by the occurrence of one or more trigger events. As such, dynamic applications 66 can be automatically deactivated after a specific interval or when other conditions occur. Dynamic application 66-1 can include one or more application-specific monitoring algorithms (e.g., for brake temperature monitoring, acoustics monitoring, smart BIT, battery monitoring, vibration monitoring, cabin temperature monitoring, heater current arc fault detection, etc.). Dynamic application 66-2 can be a stage-2 targeted PHM assessment application for monitoring the coarse data outputs from the stage-1 pre-PHM application, performing finer data analysis on the monitored data, and dynamically updating the data monitoring scheme of the hosting edge device 18. The finer data analysis can include monitoring of additional parameters from the associated sensor 16, monitoring of parameters at a higher rate, and/or monitoring of higher parameters at higher precision and/or processing.

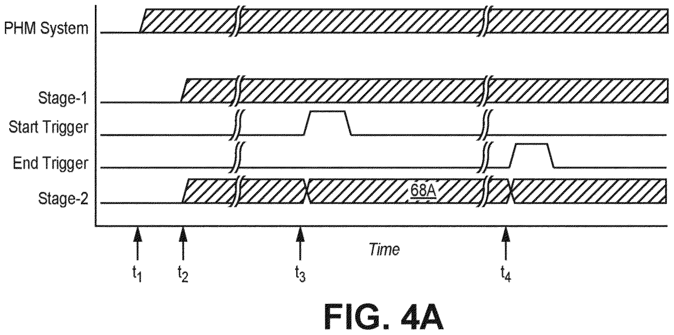

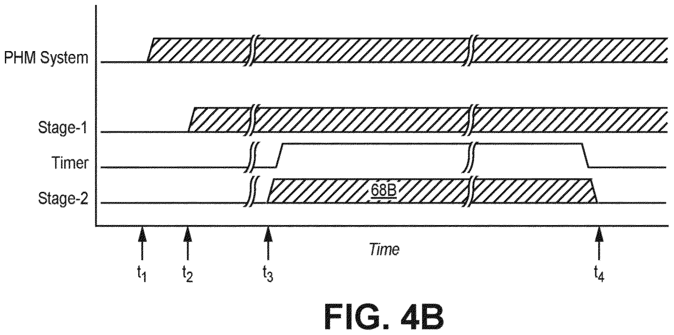

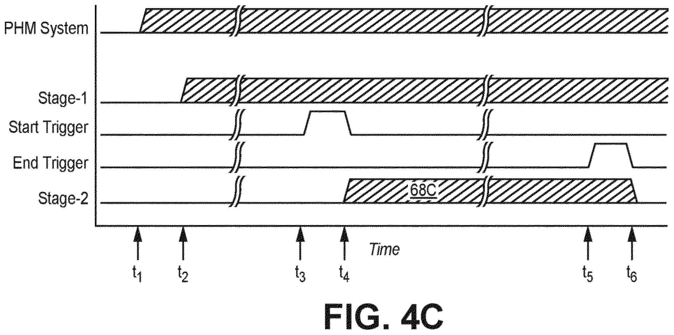

FIG. 4A is a plot, over time, of the operation of the stage-1 pre-PHM data processing application and a pre-loaded stage-2 targeted PHM assessment application. FIG. 4B is a plot, over time, of the operation of the stage-1 pre-PHM data processing application and an alternative, dynamically loaded, time-bound stage-2 targeted PHM assessment application. FIG. 4C is a plot, over time, of the operation of the stage-1 pre-PHM data processing application and a second alternative dynamically loaded, trigger-based stage-2 targeted PHM assessment application.

As shown in FIG. 4A from the top to the bottom of the y-axis, are plots of PHM system 10, the stage-1 pre-PHM data processing application, start and end triggers, and the stage-2 targeted PHM assessment application. Beginning at time t₁, system 10 is running and active. At time t₂, the stage-1 pre-PHM data processing application is activated. In the embodiment of FIG. 4A, the stage-2 targeted PHM assessment application is pre-loaded onto edge device 18 and continuously monitors the data outputs generated by the stage-1 application for trigger events. As such, the stage-2 targeted PHM assessment application begins operating at time t₂. A "start" trigger event occurs at time t₃. For any of the embodiments of FIGS. 4A-4C, a "start" trigger event can be, for example, a probe fault, or exceedance of a predetermined parameter threshold or count. Also at time t₃, the stage-2 targeted PHM assessment application begins finer data analytics, as identified by interval 68A. An "end" trigger event occurs at time t₄, and the stage-2 targeted PHM assessment application ceases finer data analytics and continues monitoring stage-1 data. An "end" trigger event can be, for example, the ending of or return to normal values of a "start" trigger event, or a different trigger event based on another monitored parameter. Interval 68A is defined by the "start" and "end" trigger events of times t₃ and t₄, respectively, and represents activation of the stage-2 targeted PHM assessment application to perform finer data analysis and generate a finer data analytics output to be sent to coordinator 20.

The embodiment of FIG. 4B is similar to the embodiment of FIG. 4A, except that the stage-2 targeted PHM assessment application is dynamically loaded and activated by coordinator 20. The stage-2 targeted PHM assessment application is time-bound such that it is configured to run for a predetermined interval (interval 68B) once activated. Activation can occur by a "start" trigger event, and deactivation with time elapsing. As with the embodiment of FIG. 4A, PHM system 10 and the stage-1 pre-PHM data processing application become active at times t₁ and t₂, respectively. At time t₃, the timer begins running as the result of a "start" trigger or other event, and the stage-2 targeted PHM assessment application is activated to perform finer data analysis. Time elapses at time t₄ and the stage-2 targeted PHM assessment application is deactivated. The finer data analytics output generated by the stage-2 targeted PHM assessment application can be sent to coordinator 20. In an alternative embodiment, activation/deactivation of the stage-2 targeted PHM assessment application may not occur simultaneously with the starting/ending of the timer, rather, interval 68B can be slightly offset from the timer due to a cycle delay in processing the event triggering the timer.

FIG. 4C shows an alternative dynamically loaded stage-2 targeted PHM assessment application configured for trigger-based activation. As with the embodiments of FIGS. 4A and 4B, PHM system 10 and the stage-1 pre-PHM data processing application become active at times t₁ and t₂, respectively. At time t₃, a "start" trigger event occurs, causing activation of the stage-2 targeted PHM assessment application to perform finer data analytics at time t₄. An "end" trigger event occurs at time t₅ leading to deactivation of the stage-2 targeted PHM assessment application at time t₆. Interval 68C defines the period of activity of the stage-2 targeted PHM assessment application. As with the embodiments of FIGS. 4A and 4B, the finer data analytics output generated by the stage-2 targeted PHM assessment application can be sent to coordinator 20.

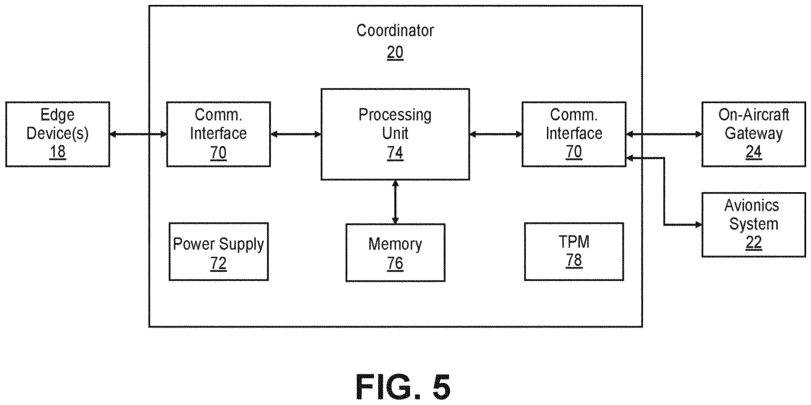

FIG. 5 is a schematic block diagram of an exemplary smart coordinator 20. As shown in FIG. 5, coordinator 20 includes communication interfaces 70 interfacing with one or more edge devices 18, on-aircraft gateway 24, and one or more avionics systems 22. Through its interface with avionics systems 22, coordinator 20 can monitor aircraft parameters such as air speed, weight-on-wheel, latitude, longitude, altitude, etc. Further included are power supply 72, processing unit 74 (e.g., a microprocessor or microcontroller), memory 76, and TPM 78. Communication interfaces 70 can be wired (e.g., Ethernet, AFDX, ARINC 429, RS232/422/485, CAN, etc.) or wireless (e.g., Bluetooth, Wi-Fi, cellular, etc.) interfaces for exchanging data with connected devices and systems. Power supply 72 can be a battery, or energy harvesting devices or other sources on the aircraft. Upon power-up, processing unit 74 retrieves edge device 18 and/or coordinator 20 updates (e.g., software, configuration information, field load bundles, etc.) from ground station 28 or cloud 26 via on-aircraft gateway 24. Each edge device 18 interfaced with coordinator 20 attempts to connect with coordinator 20 until coordinator 20 rejects or accepts the request by authenticating the requesting edge devices 18. Connected edge devices 18 are dynamically configured by coordinator 20, which transmits the latest software, configuration, trigger events, etc. to edge devices 18. Processing unit 74 accesses various data and applications from memory 76.

As discussed above with respect to FIGS. 4B and 4C, coordinator 20 can monitor the stage-1 pre-PHM coarse data outputs from an associated edge device 18, and dynamically load a stage-2 targeted assessment application to the edge device 18 if any trigger events occur. The application can be loaded using, for example, a field load bundle. Upon successful loading, coordinator 20 can activate and deactivate the stage-2 targeted assessment application as necessary based on activation parameters (e.g., trigger events, predetermined time intervals, etc.). In some embodiments, coordinator 20 can be configured to locally (i.e., within coordinator 20) implement the stage-2 targeted assessment application using processing unit 74.

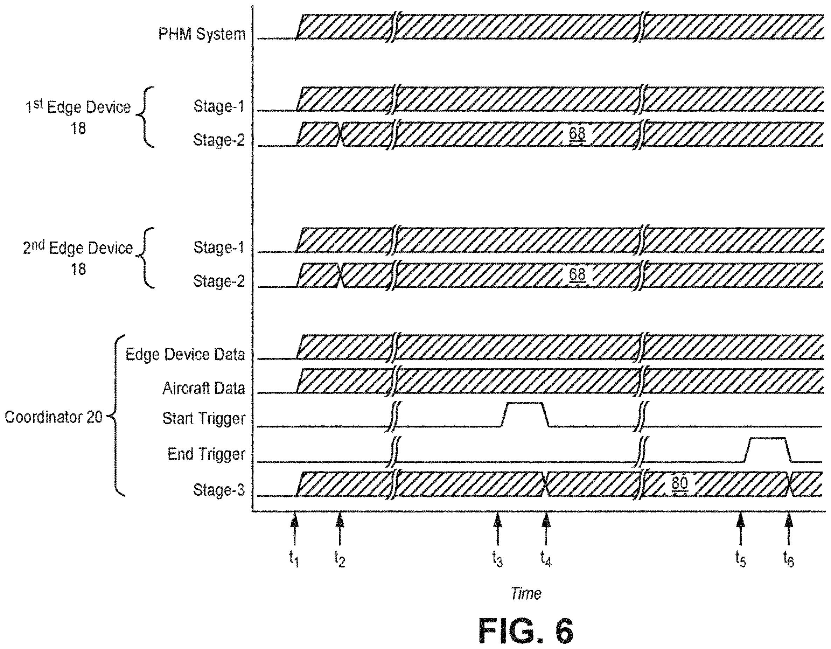

Coordinator 20 can further synthesize monitored aircraft data from avionics system(s) 22 with the coarse data (stage-1) and finer data (stage-2) analytics outputs from multiple edge devices 18 for determining trigger events and making monitoring decisions. Accordingly, coordinator 20 can implement stage-3 PHM data analytics on the synthesized data. FIG. 6 is a plot, over time, of the operation of the stage-3 data analytics application on the data monitored by coordinator 20. Shown in FIG. 6, from the top to the bottom of the y-axis, are plots of the operation of PHM system 10, the stage-1 pre-PHM data processing applications and stage-2 targeted PHM assessment applications of a first and second edge devices 18, monitored data from edge devices 18, monitored aircraft data, start and end triggers, and the stage-3 PHM data analytics application. Although only two edge devices 18 are represented on the plot of FIG. 6, coordinator 20 can monitor and analyze data from more than two edge devices 18 in alternative embodiments.

At time t₁, system 10 and the stage-1 and stage-2 applications from each edge device 18 are activated, and coordinator 20 begins monitoring edge device and aircraft data. At time t₂, the stage-2 applications from each edge device 18 are activated for an interval defined generically as interval 68. The "start" trigger event for activation of the stage-2 applications is not plotted in FIG. 6. At time t₃, a "start" trigger event, based on the monitored edge device and aircraft data, occurs and coordinator 20 begins stage-3 PHM data analytics at time t₄. At time t₅, an "end" trigger event occurs, and coordinator 20 ceases stage-3 PHM data analytics at time t₆. Interval 80 is defined by the "start" and "end" trigger events and represents activation of stage-3 PHM data analytics and generation of a stage-3 data analytics output by coordinator 20. In an alterative embodiment, stage-3 PHM data analytics can be time-bound (i.e., enabled for predetermined intervals) in a manner substantially similar to the stage-2 targeted PHM assessment application of FIG. 4B.

Data received and/or analyzed by coordinator 20 (e.g., aircraft data, stage-1, stage-2 and/or stage-3 data analytics outputs) can be timestamped and packaged before sending to cloud 26 and/or ground station 28. Cybersecurity measures, such as encryption and digital signatures, can be implemented by TPM 78 to ensure confidentiality, integrity, and authentication of the data package(s). In an alternative embodiment, system 10 can include more than one coordinator 20, and data packages can be shared among the multiple coordinators 20. Data packages are shared with cloud 26 and/or ground station 28 via on-aircraft gateway 24. Referring back to FIG. 1, on-aircraft gateway 24 is distinct from coordinator 20, however, coordinator 20 and on-aircraft gateway 24 can be grouped together in an alternative embodiment to facilitate implementation of the two components.

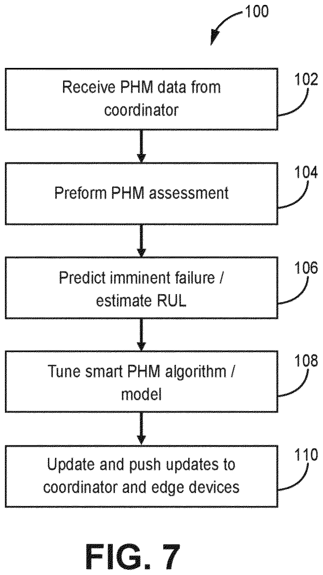

Cloud 26 can implement a cloud-hosted PHM data analytics application for analyzing, using machine learning techniques, received PHM data to predict imminent failure and estimate RUL of air data probes 12. FIG. 7 is a flowchart illustrating method 100 showing the prediction, estimation, and updating functions of cloud 26. At step 102, the data package is received by cloud 26 from coordinator 20. At step 104, cloud 26 performs a PHM assessment on the data. At step 106, the assessment can be used to predict imminent failure and estimate RUL of probe 12. This can be accomplished, for example, by using machine learning techniques to analyze received data, as well as monitored aircraft data, data history, and trend data. Supplemental flight data such as weather, flight path, service history, etc. can also be included and analyzed. At step 108, cloud 26 can automatically and intelligently tune/refine algorithms of the stage-1, stage-2 and/or stage-3 applications to improve the relevance and quality of collected data for more accurate RUL estimation and failure prediction. At step 110, the cloud-hosted PHM data analytics application can update trigger events and data collection and monitoring strategies, as necessary. Updates can be included in field load bundles and pushed/transmitted, by cloud 26, to coordinator 20 and edge devices 18.

Cloud 26 can further implement data storage for storing monitored data. Ground station 28 can access data stored in cloud 26 to perform additional analysis using, for example, advanced PHM algorithms, to further improve upon technologies and methods for estimating RUL and predicting imminent failures of probes 12. In some embodiments, ground station 28 can be configured to carry out the failure prediction and RUL estimation of method 100 in addition to, or as an alternative to cloud 26. This can be the case, for example, where it is desirable to provide redundancy, or where the functions of cloud 26 and ground station 28 overlap. RUL and failure predictions can be reported to a database monitored by and accessible to aircraft maintenance personnel. Such reporting can be accomplished via an alert or notification generated by an application of cloud 26, and/or by ground station 28. PHM system 10 allows for a tailored maintenance approach that allows for the timely replacement of faulty probes to minimize operational disruption and avoids the unnecessary replacement of healthy probes based on flight hours or other standard metrics.

### Discussion of Possible Embodiments

The following are non-exclusive descriptions of possible embodiments of the present invention.

An edge device for use in a system for monitoring a vehicle-borne probe includes a first communication interface configured to receive sensed data related to a characteristic of a heating element of a first probe, a core application module configured to host a plurality of core applications, a dynamic application module configured to host a plurality of dynamic applications, and a processing unit configured to implement the plurality of core applications on the sensed data. The plurality of core applications includes a coarse data processing application configured to monitor and analyze the sensed data to generate a first data output.

The edge device of the preceding paragraph can optionally include any one or more of the following features, configurations and/or additional components:

In the above edge device, the plurality of core applications can further include: an advanced data repository for implementing reusable data analytics algorithms, and a field loader application configured to update at least one of device configuration files, cybersecurity certificate, device-specific software, and device-specific applications.

In any of the above edge devices, the plurality of dynamic applications can include a targeted assessment application configured to monitor and analyze the first data output.

In any of the above edge devices, the targeted assessment application can be pre-loaded in the edge device.

In any of the above edge devices, the targeted assessment application can be dynamically loaded in the edge device by a coordinator in communication with the edge device.

In any of the above edge devices, the targeted assessment application can be configured to generate a second data output.

Any of the above edge devices can further include: a memory accessible by the processing unit and configured to store the plurality of core applications, and a second communication interface configured to communicate the first data output and the second data output to a coordinator of the system.

In any of the above edge devices, the plurality of dynamic applications can further include: a monitoring application for monitoring at least one of brake temperature, acoustics, smart BIT, battery, vibration, cabin temperature, and heater current arc fault.

In any of the above edge devices, the characteristic of the heating element can be one of current, capacitance, and voltage.

In any of the above edge devices, the vehicle can be an aircraft, and the first probe can be one of a pitot probe, a total air temperature probe, and an angle-of-attack probe.

A system for monitoring a vehicle-borne probe includes a coordinator in communication with any of the above edge devices and configured to receive the first data output and the second data output from the first edge device and to incorporate the first data output and second data output into a data package, and a cloud infrastructure in communication with the coordinator via a data gateway and configured to analyze the data package to estimate a remaining useful life and predict a failure of the first probe.

In the above system, the coordinator can be in communication with the first edge device and the second edge device, and the coordinator can be configured to incorporate the first data output, the second data output, and a third data output from the second edge device into the data package.

A method for operating an edge device in a system for monitoring a vehicle-borne probe includes powering up the edge device, determining, by a processing unit of the edge device, a location and identification of the edge device, receiving, by a first communication interface of the edge device, sensed data related to a characteristic of a heating element of the probe, monitoring and analyzing, by a coarse data processing application of the edge device, the sensed data to generate a first data output, and sending, via a second communication interface of the edge device, the first data output to a coordinator.

The method of the preceding paragraph can optionally include, additionally and/or alternatively, any one or more of the following features, configurations and/or additional components:

The above method can further include: monitoring, by a targeted assessment application of the edge device, the first data output, and analyzing, by the targeted assessment application, the first data output and generating a second data output.

Any of the above methods can further include: loading and activating, by the coordinator, a targeted assessment application to the edge device, and analyzing the first data output if a trigger event occurs.

In any of the above methods, the trigger event can include a start event and an end event.

In any of the above methods, the start event can include at least one of a probe fault and exceedance of a parameter threshold or count.

In any of the above methods, the end event can include one of elapsing of a predetermined amount of time after the start event, and exceedance of a parameter threshold or count.

While the invention has been described with reference to an exemplary embodiment(s), it will be understood by those skilled in the art that various changes may be made without departing from the scope of the invention as defined by the claims. In addition, many modifications may be made to adapt a particular situation or material to the teachings of the invention without departing from the scope of the claims. Therefore, it is intended that the invention not be limited to the particular embodiment(s) disclosed, but that the invention will include all embodiments falling within the scope of the appended claims.

## Claims

1. An edge device for use in a system for monitoring a vehicle-borne probe, the edge device comprising:
a first communication interface (48) configured to receive sensed data from a first sensor related to a characteristic of a heating element of a first probe (12);
a core application module (60) configured to host a plurality of core applications (62);
a dynamic application module (64) configured to host a plurality of dynamic applications (66); and
a processing unit (40) configured to implement the plurality of core applications on the sensed data, wherein the plurality of core applications comprises:
a coarse data processing application configured to continuously monitor the sensed data and to analyze the sensed data to generate a first data output; and
wherein the plurality of dynamic applications comprises a targeted assessment application simultaneously operable with the coarse data processing application to monitor the first data output and to analyze the monitored data to generate a second data output.

2. The edge device of claim 1, wherein the plurality of core applications further comprises:
an advanced data repository for implementing reusable data analytics algorithms; and
a field loader application configured to update at least one of device configuration files, cybersecurity certificate, device-specific software, and device-specific applications.

3. The edge device of claim 1 or 2, wherein the targeted assessment application is pre-loaded in the edge device, or wherein the targeted assessment application is dynamically loaded in the edge device by a coordinator in communication with the edge device.

4. The edge device of any preceding claim, wherein the edge device optionally further comprises:
a memory (42) accessible by the processing unit and configured to store the plurality of core applications; and
a second communication interface (48) configured to communicate the first data output and the second data output to a coordinator of the system.

5. The edge device of any preceding claim, wherein the plurality of dynamic applications further comprises:
a monitoring application for monitoring at least one of brake temperature, acoustics, smart BIT, battery, vibration, cabin temperature, and heater current arc fault.

6. The edge device of any preceding claim, wherein the characteristic of the heating element is one of current, capacitance, and voltage.

7. The edge device of any preceding claim, wherein the vehicle is an aircraft, and wherein the first probe is one of a pitot probe, a total air temperature probe, and an angle-of-attack probe.

8. A method for operating an edge device in a system for monitoring a vehicle-borne probe, the method comprising:
powering up the edge device;
determining, by a processing unit of the edge device, a location and identification of the edge device;
receiving, by a first communication interface of the edge device, sensed data related to a characteristic of a heating element of the probe;
monitoring and analyzing, by a coarse data processing application of the edge device, the sensed data to generate a first data output;
simultaneously monitoring, by a targeted data processing application of the edge device, the first data output;
analyzing, by the targeted assessment application, the first data output and generating a second data output; and
sending, via a second communication interface of the edge device, the first data output to a coordinator.

9. The method of claim 8 and further comprising:
sending, via the second communication interface of the edge device, the second data output to the coordinator.

10. The method of claim 8 and further comprising:
loading and activating, by the coordinator, a targeted assessment application to the edge device; and
analyzing the first data output if a trigger event occurs.

11. The method of claim 10, wherein the trigger event comprises a start event and an end event, and optionally wherein the start event comprises at least one of a probe fault and exceedance of a parameter threshold or count, and further optionally wherein the end event comprises one of elapsing of a predetermined amount of time after the start event, and exceedance of a parameter threshold or count.

## Patentansprüche

1. Randvorrichtung zur Verwendung in einem System zum Überwachen einer fahrzeuggestützten Sonde, wobei die Randvorrichtung Folgendes umfasst:
eine erste Kommunikationsschnittstelle (48), die dazu konfiguriert ist, erfasste Daten, die sich auf eine Eigenschaft eines Heizelements einer ersten Sonde (12) beziehen, von einem ersten Sensor zu empfangen;
ein Modul (60) für Kernanwendungen, das dazu konfiguriert ist, eine Vielzahl von Kernanwendungen (62) zu hosten;
ein Modul (64) für dynamische Anwendungen, das dazu konfiguriert ist, eine Vielzahl von dynamischen Anwendungen (66) zu hosten; und
eine Verarbeitungseinheit (40), die dazu konfiguriert ist, die Vielzahl von Kernanwendungen an den erfassten Daten zu implementieren, wobei die Vielzahl von Kernanwendungen Folgendes umfasst:
eine Anwendung für grobe Datenverarbeitung, die dazu konfiguriert ist, die erfassten Daten kontinuierlich zu überwachen und zu analysieren, um eine erste Datenausgabe zu generieren; und
wobei die Vielzahl von dynamischen Anwendungen eine Anwendung für gezielte Bewertung umfasst, die gleichzeitig mit der Anwendung für grobe Datenverarbeitung ausführbar ist, um die erste Datenausgabe zu überwachen und die überwachten Daten zu analysieren, um eine zweite Datenausgabe zu generieren.

2. Randvorrichtung nach Anspruch 1, wobei die Vielzahl von Kernanwendungen ferner Folgendes umfasst:
ein erweitertes Datenarchiv zum Implementieren wiederverwendbarer Datenanalysealgorithmen; und
eine Datenfeldladeanwendung, die dazu konfiguriert ist, mindestens eines von Vorrichtungskonfigurationsdateien, einem Cybersicherheitszertifikat, vorrichtungsspezifischer Software und vorrichtungsspezifischen Anwendungen zu aktualisieren.

3. Randvorrichtung nach Anspruch 1 oder 2, wobei die Anwendung für gezielte Bewertung bereits in der Randvorrichtung geladen ist oder wobei die Anwendung für gezielte Bewertung durch einen Koordinator in Kommunikation mit der Randvorrichtung dynamisch in die Randvorrichtung geladen wird.

4. Randvorrichtung nach einem vorhergehenden Anspruch, wobei die Randvorrichtung optional ferner Folgendes umfasst:
einen Speicher (42), auf den die Verarbeitungseinheit zugreifen kann und der dazu konfiguriert ist, die Vielzahl von Kernanwendungen zu speichern; und
eine zweite Kommunikationsschnittstelle (48), die dazu konfiguriert ist, die erste Datenausgabe und die zweite Datenausgabe an einen Koordinator des Systems zu kommunizieren.

5. Randvorrichtung nach einem vorhergehenden Anspruch, wobei die Vielzahl von dynamischen Anwendungen ferner Folgendes umfasst: eine Überwachungsanwendung zum Überwachen von mindestens einem von Bremsentemperatur, Akustik, Smart BIT, einer Batterie, Vibration, Kabinentemperatur und einem Heizstromlichtbogenfehler.

6. Randvorrichtung nach einem vorhergehenden Anspruch, wobei die Eigenschaft des Heizelements eines von Stromstärke, Kapazität und Spannung ist.

7. Randvorrichtung nach einem vorhergehenden Anspruch, wobei das Fahrzeug ein Luftfahrzeug ist und wobei die erste Sonde eine Pitotsonde, eine Gesamtlufttemperatursonde oder eine Anstellwinkelsonde ist.

8. Verfahren zum Betreiben einer Randvorrichtung in einem System zum Überwachen einer fahrzeuggestützten Sonde, wobei das Verfahren Folgendes umfasst:
Hochfahren der Randvorrichtung;
Bestimmen eines Standorts und einer Identifikation der Randvorrichtung durch eine Verarbeitungseinheit der Randvorrichtung;
Empfangen von erfassten Daten, die sich auf eine Eigenschaft eines Heizelements der Sonde beziehen, über eine erste Kommunikationsschnittstelle der Randvorrichtung;
Überwachen und Analysieren der erfassten Daten durch eine Anwendung für grobe Datenverarbeitung der Randvorrichtung, um eine erste Datenausgabe zu generieren;
gleichzeitiges Überwachen der ersten Datenausgabe durch eine Anwendung für gezielte Datenverarbeitung der Randvorrichtung;
Analysieren der ersten Datenausgabe durch die Anwendung für gezielte Bewertung und Generieren einer zweiten Datenausgabe; und
Senden der ersten Datenausgabe an einen Koordinator über eine zweite Kommunikationsschnittstelle der Randvorrichtung.

9. Verfahren nach Anspruch 8 und ferner umfassend:
Senden der zweiten Datenausgabe an den Koordinator über die zweite Kommunikationsschnittstelle der Randvorrichtung.

10. Verfahren nach Anspruch 8 und ferner umfassend:
Laden und Aktivieren einer Anwendung für gezielte Bewertung auf der Randvorrichtung durch den Koordinator; und
Analysieren der ersten Datenausgabe, wenn ein Auslöseereignis auftritt.

11. Verfahren nach Anspruch 10, wobei das Auslöseereignis ein Startereignis und ein Endereignis umfasst und optional wobei das Startereignis mindestens eines von einem Sondenfehler und/oder einem Überschreiten eines Parameterschwellenwerts oder -zählers umfasst und ferner optional wobei das Endereignis ferner eines von Verstreichen einer vorgegebenen Zeitspanne nach dem Startereignis und einem Überschreiten eines Parameterschwellenwerts oder -zählers umfasst.

## Revendications

1. Dispositif périphérique pour utilisation dans un système de surveillance d'une sonde embarquée sur un véhicule, le dispositif périphérique comprenant :
une première interface de communication (48) configurée pour recevoir des données détectées provenant d'un premier capteur liées à une caractéristique d'un élément chauffant d'une première sonde (12) ;
un module d'application principale (60) configuré pour héberger une pluralité d'applications principales (62) ;
un module d'application dynamique (64) configuré pour héberger une pluralité d'applications dynamiques (66) ; et
une unité de traitement (40) configurée pour mettre en œuvre la pluralité d'applications principales sur les données détectées, dans lequel la pluralité d'applications principales comprend :
une application de traitement de données grossières configurée pour surveiller en continu les données détectées et pour analyser les données détectées afin de générer une première sortie de données ; et
dans lequel la pluralité d'applications dynamiques comprend une application d'évaluation ciblée pouvant fonctionner simultanément avec l'application de traitement de données grossières pour surveiller la première sortie de données et pour analyser les données surveillées afin de générer une seconde sortie de données.

2. Dispositif périphérique selon la revendication 1, dans lequel la pluralité d'applications principales comprend également :
un référentiel de données avancé pour la mise en œuvre d'algorithmes d'analyse de données réutilisables ; et
une application de chargement de terrain configurée pour mettre à jour au moins l'un des fichiers de configuration de dispositif, du certificat de cybersécurité, du logiciel spécifique au dispositif et/ou des applications spécifiques au dispositif.

3. Dispositif périphérique selon la revendication 1 ou 2, dans lequel l'application d'évaluation ciblée est préchargée dans le dispositif périphérique, ou dans lequel l'application d'évaluation ciblée est chargée dynamiquement dans le dispositif périphérique par un coordinateur en communication avec le dispositif périphérique.

4. Dispositif périphérique selon une quelconque revendication précédente, dans lequel le dispositif périphérique comprend également éventuellement :
une mémoire (42) accessible par l'unité de traitement et configurée pour stocker la pluralité d'applications principales ; et
une seconde interface de communication (48) configurée pour communiquer la première sortie de données et la seconde sortie de données à un coordinateur du système.

5. Dispositif périphérique selon une quelconque revendication précédente, dans lequel la pluralité d'applications dynamiques comprend également :
une application de surveillance permettant de surveiller au moins l'un de la température des freins, de l'acoustique, du BIT intelligent, de la batterie, des vibrations, de la température de la cabine et du défaut de l'arc de courant de chauffage.

6. Dispositif périphérique selon une quelconque revendication précédente, dans lequel la caractéristique de l'élément chauffant est l'un du courant, de la capacité et de la tension.

7. Dispositif périphérique selon une quelconque revendication précédente, dans lequel le véhicule est un aéronef, et dans lequel la première sonde est l'une d'une sonde de Pitot, d'une sonde de température totale de l'air et d'une sonde d'angle d'attaque.

8. Procédé de fonctionnement d'un dispositif périphérique dans un système de surveillance d'une sonde embarquée sur véhicule, le procédé comprenant :
la mise sous tension du dispositif périphérique ;
la détermination, au moyen d'une unité de traitement du dispositif périphérique, d'un emplacement et d'une identification du dispositif périphérique ;
la réception, par une première interface de communication du dispositif périphérique, des données détectées liées à une caractéristique d'un élément chauffant de la sonde ;
la surveillance et l'analyse, au moyen d'une application de traitement de données grossières du dispositif périphérique, des données détectées pour générer une première sortie de données ;
la surveillance simultanée, au moyen d'une application de traitement de données ciblée du dispositif périphérique, de la première sortie de données ;
l'analyse, par l'application d'évaluation ciblée, de la première sortie de données et la génération d'une seconde sortie de données ; et
l'envoi, par le biais d'une seconde interface de communication du dispositif périphérique, de la première sortie de données à un coordinateur.

9. Procédé selon la revendication 8 et comprenant également :
l'envoi, par le biais d'une seconde interface de communication du dispositif périphérique, de la seconde sortie de données au coordinateur.

10. Procédé selon la revendication 8 et comprenant également :
le chargement et l'activation, par le coordinateur, d'une application d'évaluation ciblée sur le dispositif périphérique ; et
l'analyse de la première sortie de données si un événement déclencheur se produit.

11. Procédé selon la revendication 10, dans lequel l'événement déclencheur comprend un événement de début et un événement de fin, et éventuellement dans lequel l'événement de début comprend au moins l'un d'un défaut de sonde et d'un dépassement d'un seuil ou d'un compte de paramètre, et également éventuellement dans lequel l'événement de fin comprend l'un de l'écoulement d'une durée prédéterminée après l'événement de début et le dépassement d'un seuil ou d'un compte de paramètre.
